# EUROPÄISCHE PATENTANMELDUNG

(11) **EP 3 474 321 A1**
(43) Veröffentlichungstag der Anmeldung: **24.04.2019**
(21) Anmeldenummer: 17196853.0
(22) Anmeldetag: 17.10.2017
(51) Int. Cl.: H01L 23/473

(54) **KÜHLSYSTEM**

(71) Anmelder: Siemens Aktiengesellschaft, 80333 München (DE)
(72) Erfinder: FRÜHSTÜCK, Leo, 1210 Wien (AT); NAGL, Bernhard, 3002 Purkersdorf (AT)
(74) Vertreter: Maier, Daniel Oliver

(57) **Zusammenfassung**

Kühlsystem umfassend elektronische und/oder elektrische Bauteile (2), vorzugsweise Halbleiterelemente der Leistungselektronik, sowie eine Kühlvorrichtung (1) zur Kühlung von elektronischen und/oder elektrischen Bauteilen (2) mittels eines in einem Kühlkreislauf zirkulierenden Kältemittels, die Kühlvorrichtung (1) zumindest umfassend eine Verteilerplatte (3), welche einen Vorlaufanschluss (4) für einen Vorlauf des Kühlkreislaufes sowie einen Rücklaufanschluss (5) für einen Rücklauf des Kühlkreislaufes aufweist, sowie einen mit der Verteilerplatte (3) verbundenen thermisch leitenden Kühlkörper (6), an dessen von der Verteilerplatte (3) abgewandter Außenfläche (7) elektronische und/oder elektrische Bauteile (2) angeordnet sind, wobei der Kühlkörper (6) Kühlkanäle (8) für das Kältemittel aufweist, welche mit dem Vorlaufanschluss (4) und dem Rücklaufanschluss (5) der Verteilerplatte (3) verbunden sind, wobei die Verteilerplatte (3) zumindest eine von dem Kühlkörper (6) thermisch isolierte Rücklaufleitung (13) aufweist, welche Rücklaufleitung (13) die Kühlkanäle (8) mit dem Rücklaufanschluss (5) verbindet.

## Beschreibung

### Gebiet der Erfindung

Die Erfindung betrifft ein Kühlsystem umfassend elektronische und/oder elektrische Bauteile, vorzugsweise Halbleiterelemente der Leistungselektronik, sowie eine Kühlvorrichtung zur Kühlung von elektronischen und/oder elektrischen Bauteilen mittels eines in einem Kühlkreislauf zirkulierenden Kältemittels.

### Stand der Technik

Zur Kühlung von elektronischen und/oder elektrischen Bauteilen, beispielsweise von Halbleiterelementen der Leistungselektronik, werden üblicherweise Kühlkörper eingesetzt, auf welchen die zu kühlenden Bauteile angebracht sind. Diese Kühlkörper weisen einerseits selbst eine gute thermische Leitfähigkeit auf und werden zudem von einem Kühlmedium durchströmt, um eine möglichst effiziente Ableitung der durch die elektronischen und/oder elektrischen Bauteile erzeugten Wärme zu ermöglichen.

Dabei kann das Kühlmedium entweder Luft oder ein geeignetes flüssiges Kältemittel sein. Im Zusammenhang mit Kühlkörpern, in denen flüssiges Kältemittel zum Einsatz kommt, ist es zweckmäßig, das Kältemittel in speziellen Kühlkanälen des Kühlkörpers unter den zu kühlenden Bauteilen hindurchzuführen, um den Wärmeübertrag von den zu kühlenden Bauteilen auf das Kältemittel, aber auch einen ungewollten Wärmeübertrag von Kältemittel, das bereits durch ein Bauteil erwärmt wurde, auf ein anderes, noch zu kühlendes Bauteil steuern zu können.

Elektronische und/oder elektrische Bauteile, an denen das Kältemittel als erstes vorbeigeführt wird, die also durch einen Vorlauf des Kältemittels gekühlt werden, erfahren bei solchen Kühlkörpern eine stärkere Kühlung als alle weiteren elektronischen und/oder elektrischen Bauteile, die das Kältemittel anschließend passiert - die also durch einen Rücklauf des Kältemittels gekühlt werden. Da die gegenständlichen elektronischen und/oder elektrischen Bauteile jedoch für eine maximal zulässige Temperatur (z.B. Sperrschichttemperatur) ausgelegt sind, führt dies dazu, dass ein Großteil der verwendeten Bauelemente nicht mit voller Auslastung betrieben werden können, da ja sichergestellt werden muss, dass die Temperatur des Rücklaufes im Bereich des letzten zu kühlenden Bauteils noch ausreicht, um die Betriebstemperatur dieses Bauteils unter oder gleich der maximal zulässigen Temperatur zu halten.

Um dies zu verhindern, sind verschiedene Möglichkeiten bekannt:
Durch Positionierung von Anschlüssen für den Vorlauf und den Rücklauf an zwei einander gegenüberliegenden Seiten des Kühlkörpers kann - bei entsprechender Auslegung der Kühlkanäle - sichergestellt werden, dass jedes zu kühlende elektronische und/oder elektrische Bauteil jeweils nur durch den Vorlauf des Kältemittels gekühlt wird. Anschließend wird der Rücklauf des Kältemittels direkt dem Anschluss für den Rücklauf zugeführt, sodass das erwärmte Kältemittel kein weiteres elektronisches und/oder elektrisches Bauteil passiert. Solche Kühlkörper sind allerdings in Hinsicht auf eine Vielzahl von Anwendungen unerwünscht, da die erforderliche Anordnung der Anschlüsse an gegenüberliegenden Seiten des Kühlkörpers die Handhabung bzw. den Einbau entsprechender Komponenten erheblich erschwert.

Die zweite Möglichkeit der Vermeidung des geschilderten Problems besteht darin, den Rücklauf des Kältemittels über einen Bereich des Kühlkörpers zu führen, in welchem keine elektronischen und/oder elektrischen Bauteile angeordnet sind und deshalb keine Kühlung zu erfolgen hat. Zwar kann dadurch der Anschluss für den Vorlauf und jener für den Rücklauf des Kältemittels auf derselben Seite des Kühlkörpers angebracht werden; allerdings führt dies auch dazu, dass der Kühlkörper deutlich größer ausgelegt werden muss, als durch die Größe, Anzahl und/oder Anordnung eigentlich erforderlich wäre.

### Aufgabe der Erfindung

Es ist daher eine Aufgabe der vorliegenden Erfindung ein Kühlsystem bereitzustellen, welches die oben genannten Nachteile vermeidet und eine effiziente Kühlung von elektronischen und/oder elektrischen Bauteilen erlaubt, ohne eine spezielle Anordnung von Zu- und Rücklaufanschlüssen oder einen vergrößerten Kühlkörper zu erfordern.

### Darstellung der Erfindung

Gelöst wird diese Aufgabe durch ein erfindungsgemäßes Kühlsystem umfassend elektronische und/oder elektrische Bauteile, vorzugsweise Halbleiterelemente der Leistungselektronik, sowie eine Kühlvorrichtung zur Kühlung von elektronischen und/oder elektrischen Bauteilen mittels eines in einem Kühlkreislauf zirkulierenden Kältemittels, die Kühlvorrichtung zumindest umfassend eine Verteilerplatte, welche einen Vorlaufanschluss für einen Vorlauf des Kühlkreislaufes sowie einen Rücklaufanschluss für einen Rücklauf des Kühlkreislaufes aufweist, sowie einen mit der Verteilerplatte verbundenen thermisch leitenden Kühlkörper, an dessen von der Verteilerplatte abgewandter Außenfläche elektronische und/oder elektrische Bauteile angeordnet sind, wobei der Kühlkörper Kühlkanäle für das Kältemittel aufweist, welche mit dem Vorlaufanschluss und dem Rücklaufanschluss der Verteilerplatte verbunden sind, wobei die Verteilerplatte zumindest eine von dem Kühlkörper thermisch isolierte Rücklaufleitung aufweist, welche Rücklaufleitung die Kühlkanäle mit dem Rücklaufanschluss verbindet.

Da die Rücklaufleitung von dem Kühlkörper thermisch isoliert ist, kann die Anordnung des Rücklaufanschlusses der Verteilerplatte frei gewählt werden. Die Rücklaufleitung kann in und/oder an der Verteilerplatte beliebig geführt werden, bevor sie in den Rücklaufanschluss mündet, und zwar ohne dabei in thermischer Wechselwirkung mit den auf der Außenfläche des Kühlkörpers angeordneten zu kühlenden elektronischen und/oder elektrischen Bauteilen zu geraten. Ermöglicht wird dies durch einen schichtweisen Aufbau des Kühlsystems - der Kühlkörper bildet eine, die Verteilerplatte eine zweite, von der ersten thermisch isolierte Schicht - und durch die von dem Kühlkörper thermisch isoliert in und/oder an der Verteilerplatte geführte Rücklaufleitung. Anders als bei bekannten Kühlsystemen muss die Anordnung bzw. der Verlauf der Rücklaufleitung nicht mit der Anordnung der zu kühlenden elektronischen Bauteile abgestimmt werden; insbesondere braucht die Rücklaufleitung nicht in einem Abschnitt des Kühlkörpers geführt werden, welcher Abschnitt frei von zu kühlenden elektronischen und/oder elektrischen Bauteilen gehalten wird, um zu verhindern, dass die zu kühlenden elektronischen und/oder elektrischen Bauteile durch den Rücklauf in verminderter Weise gekühlt bzw. erwärmt werden. Das erfindungsgemäße Kühlsystem ermöglicht es somit, einen Großteil der Rücklaufleitung in einem von dem Kühlkörper - und somit auch von den zu kühlenden elektronischen und/oder elektrischen Bauteilen - thermisch isolierten Bereich des Kühlsystems zu führen, wodurch eine kompakte Bauweise des Kühlsystems mit beliebig (zueinander) positionierbaren Anschlüssen für den Vorlauf und den Rücklauf des Kühlkreislaufes ermöglicht wird.

Besonders vorteilhaft ist es, wenn die Länge der Rücklaufleitung einen Großteil der Länge des Rücklaufes des im Kühlsystem geführten Kühlkreislaufes ausmacht. Dadurch wird sichergestellt, dass die zu kühlenden elektronischen bzw. elektrischen Bauteile durch den im Kühlsystem geführten Rücklauf nicht bzw. möglichst wenig beeinflusst werden. Besonders bevorzugt wird der Rücklauf so schnell wie möglich nach einmaligem Passieren eines zu kühlenden elektronischen bzw. elektrischen Bauteils in die thermisch isolierte Verteilerplatte geführt, um eine Erhitzung der Bauteile durch den Rücklauf zu vermeiden.

Gemäß einer bevorzugten Ausführungsform der erfindungsgemäßen Kühlsystems ist es vorgesehen, dass die Kühlvorrichtung einen weiteren Kühlkörper umfasst, welcher mit der Verteilerplatte verbunden ist, wobei an einer Außenfläche des weiteren Kühlkörpers, welche von der Verteilerplatte abgewandt ist, ebenfalls elektronische und/oder elektrische Bauteile angeordnet sind und wobei der weitere Kühlkörper Kühlkanäle für das Kältemittel aufweist, welche mit dem Vorlaufanschluss und dem Rücklaufanschluss der Verteilerplatte verbunden sind, wobei die Verteilerplatte zumindest eine von dem weiteren Kühlkörper thermisch isolierte Rücklaufleitung für den weiteren Kühlkörper aufweist, welche die Kühlkanäle des weiteren Kühlkörpers mit dem Rücklaufanschluss verbindet.

Dadurch wird eine effizientere Nutzung des Kühlsystems gewährleistet, da sowohl an dem Kühlkörper als auch an dem weiteren Kühlkörper, welcher vorzugsweise parallel zu dem Kühlkörper angeordnet ist, die zu kühlenden elektronischen Bauteile angeordnet sind. Die Rücklaufleitung für den weiteren Kühlkörper der Verteilerplatte ist dabei sowohl von dem Kühlkörper als auch von dem weiteren Kühlkörper thermisch isoliert, wodurch die oben in Bezug auf den Kühlkörper beschriebenen Vorteile auch hinsichtlich des weiteren Kühlkörpers genutzt werden können. Besonders vorteilhaft ist es wiederum, wenn die Länge der Rücklaufleitung für den weiteren Kühlkörper einen Großteil der Länge des im Kühlsystem geführten Rücklaufes des Kühlkreislaufes für den weiteren Kühlkörper ausmacht. Dabei kann die Rücklaufleitung für den weiteren Kühlkörper als separate Leitung ausgebildet sein, welche an ihrem einen Ende mit den Kühlkanälen des weiteren Kühlkörpers und an ihrem anderen Ende mit dem Rücklaufanschluss der Verteilerplatte verbunden ist.

Bei einer anderen bevorzugten Ausführungsform der erfindungsgemäßen Kühlsystems ist es hingegen vorgesehen, dass die Rücklaufleitung für den weiteren Kühlkörper zumindest abschnittsweise als Teil der Rücklaufleitung für den Kühlkörper ausgebildet ist.

Dadurch wird eine einfache Struktur des Kühlsystems, insbesondere der Verteilerplatte, sichergestellt.

Eine weitere Vereinfachung des Aufbaus des erfindungsgemäßen Kühlsystems in Kombination mit einer möglichst effizienten Kühlleistung wird bei einer weiteren bevorzugten Ausführungsform des erfindungsgemäßen Kühlsystems dadurch ermöglicht, dass der Kühlkörper und/oder der weitere Kühlkörper aus einem Material mit einer Wärmeleitfähigkeit zwischen 70 W/(m K) und 240 W/(m K), beispielsweise aus Aluminium oder einer Aluminiumlegierung, gefertigt ist, wobei die Kühlkanäle in den Kühlkörper und/oder in den weiteren Kühlkörper eingebracht sind. Bevorzugt sind die Kühlkanäle dabei in den Kühlkörper und/oder den weiteren Kühlkörper gefräst oder nicht-spanend durch Guss erzeugt. Insbesondere kann es vorteilhaft sein, wenn die Kühlkanäle derart gefertigt sind, dass sie dem Kühlkörper und/oder dem weiteren Kühlkörper eine einseitig offene Struktur verleihen.

Insbesondere wird dadurch die Anordnung der Kühlkanäle und deren Abstimmung mit der - von Fall zu Fall abweichenden - Positionierung der zu kühlenden elektronischen und/oder elektrischen Bauteile erheblich erleichtert. Da dies durch das Einbringen, insbesondere Fräsen, der Kühlkanäle in den Kühlkörper und/oder den weiteren Kühlkörper bzw. durch Gießen der Kühlkörper erreicht wird, ist eine zusätzliche Abdichtung der Kühlkanäle erforderlich.

Bei einer besonders bevorzugten Ausführungsform der erfindungsgemäßen Kühlsystems ist es vorgesehen, dass die thermische Isolierung zwischen der Verteilerplatte und dem Kühlkörper durch eine zwischen der Verteilerplatte und dem Kühlkörper angeordnete Abdichtungsplatte und/oder die thermische Isolierung zwischen der Verteilerplatte und dem weiteren Kühlkörper durch eine zwischen der Verteilerplatte und dem weiteren Kühlkörper angeordnete Abdichtungsplatte realisiert ist, wobei die Abdichtungsplatte zur Abdichtung der Kühlkanäle dient und Durchtrittsöffnungen zur Verbindung der Kühlkanäle mit der zugeordneten Rücklaufleitung und dem Vorlaufanschluss aufweist.

Die Abdichtungsplatte dient somit einerseits zur thermischen Isolierung der Verteilerplatte von dem Kühlkörper und gegebenenfalls dem weiteren Kühlkörper bzw. zur thermischen Isolierung der Rücklaufleitung von den Kühlkörpern; gleichzeitig wird jedoch auch eine Abdichtung der Kühlkanäle sichergestellt. Dies wird vorzugsweise dadurch erreicht, dass die Abdichtungsplatte flächig an der die Kühlkanäle aufweisenden Seite des Kühlkörpers bzw. des weiteren Kühlkörpers anliegt und die Kühlkanäle - bis auf jene Stellen, an denen die Durchtrittsöffnungen angeordnet sind - verschließt. Die Durchtrittsöffnungen ermöglichen dabei den Druchtritt von Kältemittel aus der Verteilerplatte - also des Vorlaufes des Kühlkreislaufes - durch die Abdichtungsplatte hindurch in die Kühlkanäle des jeweiligen Kühlkörpers sowie den Durchtritt von Kältemittel aus den Kühlkanälen durch die Abdichtungsplatte hindurch in die Rücklaufleitung der Verteilerplatte. Dabei bildet jener Anteil des Kältemittels des Kühlkreislaufes, welcher sich in Richtung des Kühlkreislaufes von einem zu kühlenden elektronischen und/oder elektrischen Bauteil bis zum Rücklaufanschluss bewegt, den Rücklauf des Kühlkreislaufes. Dabei weist der Rücklauf des Kühlkreislaufes eine höhere Temperatur als der Vorlauf des Kühlkreislaufes auf.

Bei einer weiteren bevorzugten Ausführungsform des erfindungsgemäßen Kühlsystems ist es vorgesehen, dass die Abdichtungsplatte aus einem Elastomer oder aus einem Elastomer enthaltenden Verbundwerkstoff gefertigt ist.

Dabei erfüllt die Abdichtungsplatte die Funktion einer Flanschdichtung, welche zwischen der Verteilerplatte und dem jeweiligen Kühlkörper eingeklemmt ist. Durch die Flexibilität des Materials der Abdichtungsplatte wird eine zuverlässige Abdichtung der Kühlkanäle gewährleistet; durch die thermischen Eigenschaften des Materials der Abdichtungsplatte wird die thermische Isolierung zwischen Verteilerplatte und dem jeweiligen Kühlkörper erreicht.

Wiederum eine andere Ausführungsform des erfindungsgemäßen Kühlsystems sieht vor, dass die Verteilerplatte selbst, insbesondere ein Abschnitt der Verteilerplatte, mit welchem Abschnitt die Verteilerplatte, vorzugsweise flächig, besonders bevorzugt flächendeckend, an dem Kühlkörper bzw. dem weiteren Kühlkörper anliegt, die thermische Isolierung zwischen der Verteilerplatte und dem jeweiligen Kühlkörper vermittelt. Deshalb ist es bei einer anderen Ausführungsform vorgesehen, dass die thermische Isolierung zwischen der Verteilerplatte und dem Kühlkörper und/oder die thermische Isolierung zwischen der Verteilerplatte und dem weiteren Kühlkörper durch ein Material, vorzugsweise ein Elastomer oder einen Elastomer enthaltenden Verbundwerkstoff, aus welchem Material die Verteilerplatte gefertigt ist, realisiert ist, wobei die Verteilerplatte zur Abdichtung der Kühlkanäle dient.

Grundsätzlich ist es vorteilhaft und bei einer besonders bevorzugten Ausführungsform des erfindungsgemäßen Kühlsystems auch vorgesehen, dass das Material, aus welchem die die Verteilerplatte, und/oder die Abdichtungsplatte gefertigt ist, eine Wärmeleitfähigkeit zwischen 1 W/(m K) und 0,004 W/(m K) aufweist.

Um eine besonders effiziente thermische Abschirmung der Rücklaufleitung von den zu kühlenden elektronischen Bauteilen zu erreichen, ist es bei einer anderen besonders bevorzugten Ausführungsform des erfindungsgemäßen Kühlsystems vorgesehen, dass die Rücklaufleitung und/oder die Rücklaufleitung für den weiteren Kühlkörper im Inneren der Verteilerplatte verlaufend angeordnet sind, und vorzugsweise als Bohrungen der Verteilerplatte ausgebildet sind.

### Kurze Beschreibung der Figuren

Die Erfindung wird nun anhand eines Ausführungsbeispiels näher erläutert. Die Zeichnungen sind beispielhaft und sollen den Erfindungsgedanken zwar darlegen, ihn aber keinesfalls einengen oder gar abschließend wiedergeben.

Dabei zeigt:
Fig. 1 ein Ausführungsbeispiel des erfindungsgemäßen Kühlsystems
Fig. 2 die erfindungsgemäße Kühlvorrichtung des in Fig. 1 dargestellten Kühlsystems in einer Explosionsansicht

### Wege zur Ausführung der Erfindung

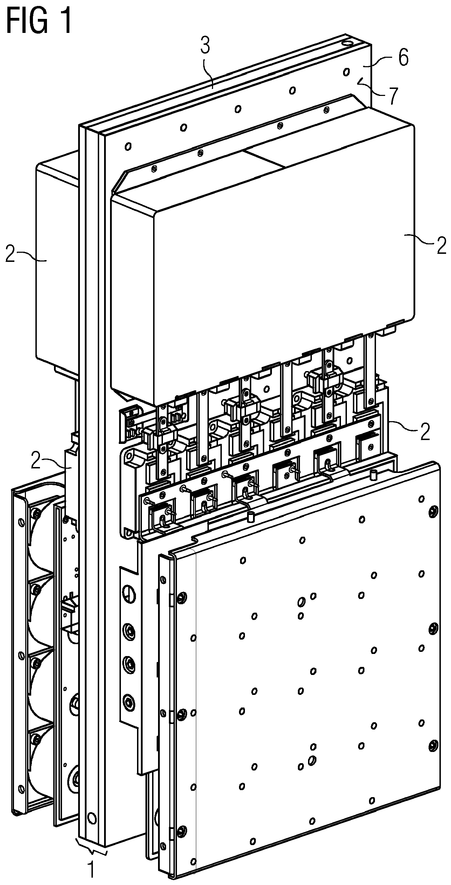

In Fig. 1 ist ein Ausführungsbeispiel des erfindungsgemäßen Kühlsystems dargestellt. Dabei sind elektronische Bauteile 2, nämlich Halbleiterelemente eines leistungselektronischen Bauelementes, an einem Kühlkörper 6 und an einem weiteren Kühlkörper 12 der Kühlvorrichtung 1 angeordnet. Kältemittel, welches in einem Kühlkreislauf zirkuliert und dabei die Kühlvorrichtung 1 durchströmt, trägt dabei zur notwendigen Kühlung der elektronischen Bauteile 2 während ihres bestimmungsgemäßen Betriebs bei.

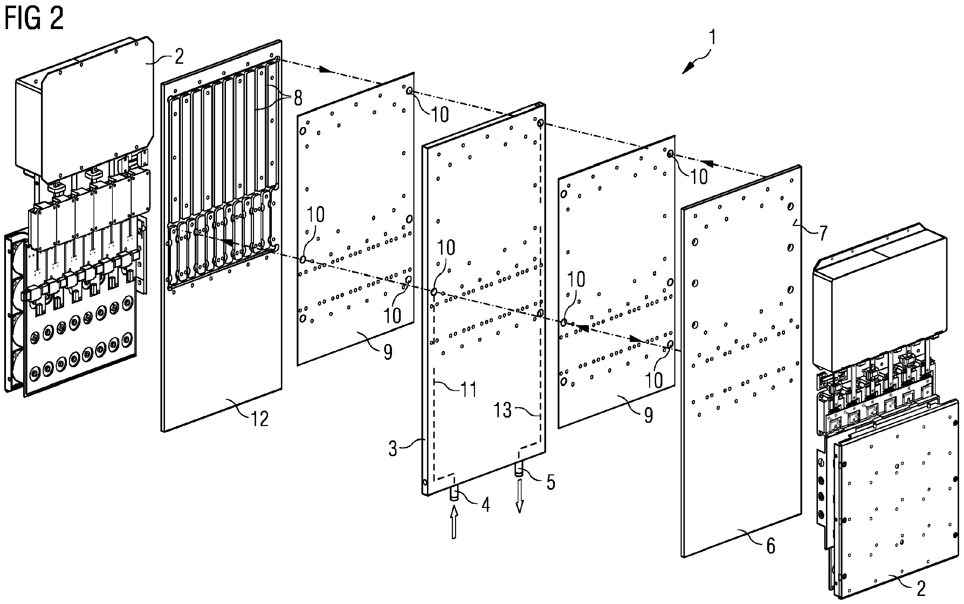

Fig. 2 zeigt die Kühlvorrichtung 1 und somit das erfindungsgemäße Kühlsystem ohne die in Fig. 1 dargestellten zu kühlenden elektronischen Bauteile 2. Die Pfeile deuten dabei den Kühlkreislauf innerhalb der Kühlvorrichtung 1 an. Eine Verteilerplatte 3 weist einen Vorlaufanschluss 4, über welchen der Kühlvorrichtung 1 in ihrem Betriebszustand kaltes Kältemittel des Kühlkreislaufes zugeführt wird, und einen Rücklaufanschluss 5 auf, über welchen Rücklaufanschluss 5 Kältemittel des Kühlkreislaufes, das durch die Kühlung eines elektronischen Bauteils 2 erwärmt wurde, die Kühlvorrichtung 1 in ihrem Betriebszustand wieder verlässt.

Der Kühlkörper 6 und der weitere Kühlkörper 12 sind an jeweils einer Seite der Verteilerplatte 3 angebracht, vorzugsweise sind sie mit der Verteilerplatte 3 verschraubt. Im Betriebszustand des Kühlsystems sind jeweils auf einer von der Verteilerplatte 3 abgewandten Außenfläche 7 des Kühlkörpers 6 und des weiteren Kühlkörpers 12 die zu kühlenden elektronischen Bauteile 2 angeordnet; vorzugsweise sind diese durch entsprechende Bohrungen des jeweiligen Kühlkörpers 6, 12 hindurch mit der Verteilerplatte 3 verschraubt. Der Kühlkörper 6 und der weitere Kühlkörper 12 weisen jeweils Kühlkanäle 8 auf, wobei diese Kühlkanäle 8 im konkreten Ausführungsbeispiel an der von der Außenfläche 7 abgewandten Außenseite in den jeweiligen Kühlkörper 6, 12 eingebracht, vorzugsweise gefräst, sind.

Zwischen der Verteilerplatte 3 und dem Kühlkörper 6 sowie zwischen der Verteilerplatte 3 und dem weiteren Kühlkörper 12 ist jeweils eine Abdichtungsplatte 9 angeordnet. Diese Abdichtungsplatte 9 erfüllt einerseits die Funktion einer Flanschdichtung für die Kühlkanäle 8; gleichzeitig dient die Abdichtungsplatte 9 aber auch zur thermischen Isolierung der Verteilerplatte 3 von dem Kühlkörper 6 bzw. dem weiteren Kühlkörper 12. Um eine Überleitung von Kältemittel aus der Verteilerplatte in den Kühlkörper 6 und den weiteren Kühlkörper 12, und auch aus den Kühlkörpern 6, 12 in die Verteilerplatte 3, zu ermöglichen, weist jede Abdichtungsplatte 9 Durchtrittsöffnungen 10 auf. Über diese Durchtrittsöffnungen 10 ist eine mit dem Vorlaufanschluss 4 verbundene Vorlaufleitung 11 der Verteilerplatte 3 mit den Kühlkanälen 8 verbunden. Außerdem sind die Kühlkanäle 8 über andere Durchtrittsöffnungen 10 mit einer in den Rücklaufanschluss 5 mündenden Rücklaufleitung 13 der Verteilerplatte 3 verbunden.

Sowohl die Abdichtung der Kühlkanäle 8 als auch die thermische Isolierung der Verteilerplatte 3 von dem Kühlkörper 6 bzw. dem weiteren Kühlkörper 12 kann bei anderen, vom Erfindungsgedanken mitumfassten Ausführungsvarianten der erfindungsgemäßen Kühlvorrichtung 1 anstatt durch die Abdichtungsplatte 9 durch andere Mittel erzielt werden - beispielsweise durch eine geeignete Material- und Geometriewahl der Verteilerplatte 3 selbst bzw. eines mit dem jeweiligen Kühlkörper 6, 12 in Kontakt stehenden Abschnittes der Verteilerplatte 3.

Die Funktionsweise des erfindungsgemäßen Kühlsystems wird nun unter Bezugnahme auf das in Fig. 1 und 2 beschriebene Ausführungsbeispiel erläutert:
Im Betriebszustand des erfindungsgemäßen Kühlsystems, in welchem die Kühlvorrichtung 1 wie in Fig. 1 gezeigt zusammengebaut ist, sind die zu kühlenden elektronischen Bauteile 2 an der Kühlvorrichtung 1 angeordnet und ist die Kühlvorrichtung 1 über den Vorlaufanschluss 4 und den Rücklaufanschluss 5 mit dem Kühlkreislauf, in welchem Kältemittel zirkuliert, verbunden. Dadurch kann Kältemittel über den Vorlaufanschluss 4 in die Verteilerplatte 3 einströmen, wo es über die Vorlaufleitung 11 und eine der Durchtrittsöffnungen 10 in die Kühlkanäle 8 des Kühlkörpers 6 und des weiteren Kühlkörpers 12 geführt wird. Nachdem es die Kühlkanäle 8 in der durch ihre Auslegung vorgegebenen Richtung durchströmt und dabei Wärme von den zu kühlenden elektronischen Bauteilen 2 aufgenommen hat, strömt das Kältemittel über eine andere der Durchtrittsöffnungen 10 in die Rücklaufleitung 13 der Verteilerplatte 3. Die Rücklaufleitung 13 mündet schließlich in den Rücklaufanschluss 5 und das Kältemittel kann die Kühlvorrichtung 1 über diesen Rücklaufanschluss 5 wieder verlassen, um für einen weiteren Kühlzyklus aufbereitet zu werden.

Es kann jeweils eine eigene Rücklaufleitung 13 für den Kühlkörper 6 und den weiteren Kühlkörper 12, oder aber - wie im dargestellten Ausführungsbeispiel - eine gemeinsame Rücklaufleitung 13 für beide Kühlkörper 6, 12 vorgesehen sein. Es ist vorteilhaft, wenn die Rücklaufleitung 13 mehr als 80%, vorzugsweise 85%, besonders bevorzugt 90%, der Länge der Verteilerplatte 3 einnimmt. Dabei kann die Rücklaufleitung 13 als Bohrung im Inneren der Verteilerplatte 3 ausgebildet sein.

Da die Verteilerplatte 3, insbesondere die Rücklaufleitung 13 der Verteilerplatte 3, von dem Kühlkörper 6 bzw. dem weiteren Kühlkörper 12 thermisch isoliert ist, ist es möglich, die Rücklaufleitung 13 innerhalb der Verteilerplatte 3 - oder aber an einer Außenseite der Verteilerplatte 3 - jedenfalls aber in beliebiger Weise in oder an der Verteilerplatte 3 entlang zu führen, ohne dass dabei ein für die Kühlleistung relevanter Wärmeübertrag auf die zu kühlenden elektronischen Bauteile 2 stattfindet. Dadurch kann der Rücklaufanschluss 5 an einer beliebigen Seite der Kühlvorrichtung 1 und insbesondere an jener Seite der Kühlvorrichtung 1, an der sich auch der Vorlaufanschluss 4 befindet, angeordnet werden. Dies kann bei allen Ausführungsformen des erfindungsgemäßen Kühlsystems erreicht werden, ohne dafür eine Vergrößerung der Länge und/oder Breite des Kühlkörpers 6 oder des weiteren Kühlkörpers 12 vorsehen zu müssen.

Insbesondere sind auch solche Ausführungsbeispiele des beschriebenen Kühlsystems vom Erfindungsgedanken abgedeckt, in denen die Kühlvorrichtung nur aus der Verteilerplatte 3 und einem einzigen Kühlkörper 6 besteht, wobei je nach Ausbildung der Verteilerplatte 3 eine Abdichtungsplatte 9 vorgesehen oder weggelassen werden kann, aber die Kühlvorrichtung jedenfalls keinen weiteren Kühlkörper 12 aufweist.

### Bezugszeichen

- 1: Kühlvorrichtung
- 2: elektronische Bauteile
- 3: Verteilerplatte
- 4: Vorlaufanschluss
- 5: Rücklaufanschluss
- 6: Kühlkörper
- 7: Außenfläche
- 8: Kühlkanäle
- 9: Abdichtungsplatte
- 10: Durchtrittsöffnungen
- 11: Vorlaufleitung
- 12: weiterer Kühlkörper
- 13: Rücklaufleitung

## Patentansprüche

1. Kühlsystem umfassend
- elektronische und/oder elektrische Bauteile (2), vorzugsweise Halbleiterelemente der Leistungselektronik, sowie
- eine Kühlvorrichtung (1) zur Kühlung von elektronischen und/oder elektrischen Bauteilen (2) mittels eines in einem Kühlkreislauf zirkulierenden Kältemittels, die Kühlvorrichtung (1) zumindest umfassend
- eine Verteilerplatte (3), welche einen Vorlaufanschluss (4) für einen Vorlauf des Kühlkreislaufes sowie einen Rücklaufanschluss (5) für einen Rücklauf des Kühlkreislaufes aufweist, sowie
- einen mit der Verteilerplatte (3) verbundenen thermisch leitenden Kühlkörper (6), an dessen von der Verteilerplatte (3) abgewandter Außenfläche (7) elektronische und/oder elektrische Bauteile (2) angeordnet sind, wobei der Kühlkörper (6) Kühlkanäle (8) für das Kältemittel aufweist, welche mit dem Vorlaufanschluss (4) und dem Rücklaufanschluss (5) der Verteilerplatte (3) verbunden sind,
wobei die Verteilerplatte (3) zumindest eine von dem Kühlkörper (6) thermisch isolierte Rücklaufleitung (13) aufweist, welche Rücklaufleitung (13) die Kühlkanäle (8) mit dem Rücklaufanschluss (5) verbindet.

2. Kühlsystem nach Anspruch 1, **dadurch gekennzeichnet, dass** die Kühlvorrichtung (1) einen weiteren Kühlkörper (12) umfasst, welcher mit der Verteilerplatte (3) verbunden ist, wobei an einer Außenfläche (7) des weiteren Kühlkörpers (12), welche von der Verteilerplatte (3) abgewandt ist, ebenfalls elektronische und/oder elektrische Bauteile (2) angeordnet sind und wobei der weitere Kühlkörper (12) Kühlkanäle (8) für das Kältemittel aufweist, welche mit dem Vorlaufanschluss (4) und dem Rücklaufanschluss (5) der Verteilerplatte (3) verbunden sind, wobei die Verteilerplatte (3) zumindest eine von dem weiteren Kühlkörper (12) thermisch isolierte Rücklaufleitung für den weiteren Kühlkörper (12) aufweist, welche die Kühlkanäle (8) des weiteren Kühlkörpers (12) mit dem Rücklaufanschluss (5) verbindet.

3. Kühlsystem nach Anspruch 2, **dadurch gekennzeichnet, dass** die Rücklaufleitung für den weiteren Kühlkörper (12) zumindest abschnittsweise als Teil der Rücklaufleitung (13) für den Kühlkörper (6) ausgebildet ist.

4. Kühlsystem nach einem der Ansprüche 1 bis 3, **dadurch gekennzeichnet, dass** der Kühlkörper (6) und/oder der weitere Kühlkörper (12) aus einem Material mit einer Wärmeleitfähigkeit zwischen 70 W/(m K) und 240 W/(m K), beispielsweise aus Aluminium oder einer Aluminiumlegierung, gefertigt ist, wobei die Kühlkanäle (8) in den Kühlkörper (6) und/oder in den weiteren Kühlkörper (12) eingebracht, vorzugsweise gefräst, sind.

5. Kühlsystem nach einem der Ansprüche 1 bis 4, **dadurch gekennzeichnet, dass** die thermische Isolierung zwischen der Verteilerplatte (3) und dem Kühlkörper (6) durch eine zwischen der Verteilerplatte (3) und dem Kühlkörper (6) angeordnete Abdichtungsplatte (9) und/oder, sofern abhängig von Anspruch 2, die thermische Isolierung zwischen der Verteilerplatte (3) und dem weiteren Kühlkörper (12) durch eine zwischen der Verteilerplatte (3) und dem weiteren Kühlkörper (12) angeordnete Abdichtungsplatte (9) realisiert ist, wobei die Abdichtungsplatte (9) zur Abdichtung der Kühlkanäle (8) dient und Durchtrittsöffnungen (10) zur Verbindung der Kühlkanäle (8) mit der zugeordneten Rücklaufleitung (13) und dem Vorlaufanschluss (4) aufweist.

6. Kühlsystem nach Anspruch 5, **dadurch gekennzeichnet, dass** die Abdichtungsplatte (9) aus einem Elastomer oder aus einem Elastomer enthaltenden Verbundwerkstoff gefertigt ist.

7. Kühlsystem nach einem der Ansprüche 1 bis 4, **dadurch gekennzeichnet, dass** die thermische Isolierung zwischen der Verteilerplatte (3) und dem Kühlkörper (6) und/oder, sofern abhängig von Anspruch 2, die thermische Isolierung zwischen der Verteilerplatte (3) und dem weiteren Kühlkörper (12) durch ein Material, vorzugsweise ein Elastomer oder einen Elastomer enthaltenden Verbundwerkstoff, aus welchem Material die Verteilerplatte (3) gefertigt ist, realisiert ist, wobei die Verteilerplatte (3) zur Abdichtung der Kühlkanäle (8) dient.

8. Kühlsystem nach einem der Ansprüche 1 bis 7, **dadurch gekennzeichnet, dass** das Material, aus welchem die die Verteilerplatte (3), und/oder, sofern abhängig von Anspruch 5, die Abdichtungsplatte (9) gefertigt ist, eine Wärmeleitfähigkeit zwischen 1 W/(m K) und 0,004 W/(m K) aufweist.

9. Kühlsystem nach einem der Ansprüche 1 bis 8, **dadurch gekennzeichnet, dass** die Rücklaufleitung (13) und/oder, sofern abhängig von Anspruch 2, die Rücklaufleitung für den weiteren Kühlkörper (12) im Inneren der Verteilerplatte (3) verlaufend angeordnet sind, und vorzugsweise als Bohrungen der Verteilerplatte (3) ausgebildet sind.
